# EUROPEAN PATENT SPECIFICATION

(11) **EP 1 079 512 B1**
(45) Date of publication and mention of the grant of the patent: **09.06.2004**
(21) Application number: 00306529.9
(22) Date of filing: 31.07.2000
(51) Int. Cl.: H03B 5/12

(54) **Two-band oscillating device**
Zweibandoszillatorgerät
Dispositif d'oscillateur à deux bandes

(30) Priority: 19.08.1999 JP 23259799; 24.01.2000 JP 2000017948
(43) Date of publication of application: 28.02.2001
(73) Proprietor: ALPS ELECTRIC CO., LTD., Ota-ku Tokyo 145 (JP)
(72) Inventor: Tanemura, Takeshi, c/o Alps Electric Co., Ltd, Tokyo 145 (JP); Ikarashi, Yasuhiro, c/o Alps Electric Co., Ltd, Tokyo 145 (JP)
(74) Representative: Kensett, John Hinton

(56) References cited:
- EP-A- 0 845 855
- PATENT ABSTRACTS OF JAPAN vol. 013, no. 450 (E-830), 11 October 1989 (1989-10-11) & JP 01 173908 A (HITACHI LTD), 10 July 1989 (1989-07-10)

## Description

The present invention relates to a two-band oscillating device for use in a portable telephone, which is shared by two different systems.

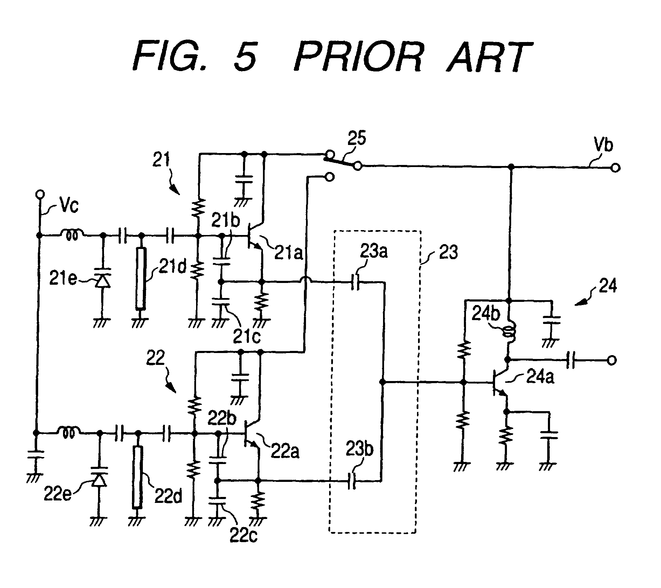

Fig. 5 shows the construction of a conventional two-band oscillating device comprising a first oscillator 21, a second oscillator 22, a coupled circuit 23, and an amplifier 24. The first oscillator 21 produces an oscillation signal in a low frequency band (Lf) of about 880 MHz to 940 MHz. The second oscillator 22 produces an oscillation signal in a higher frequency band (Hf) of about 1805 MHz to 1920 MHz.

A power supply voltage (Vb) is applied to either the first oscillator 21 or second oscillator 22 by a change-over switch 25. The oscillator to which the power supply voltage is applied operates in an alternative way and outputs an oscillation signal. Each of the oscillation signals is supplied to the amplifier 24 via the coupled circuit 23.

Each of the first and second oscillators 21 and 22 takes the form of a voltage-controlled collector-grounded Colpitts oscillator. The first oscillator 21 has a first oscillation transistor 21a, two feedback capacitors 21b and 21c, a first strip line 21d as an inductance device, and a first varactor diode 21e. Similarly, the second oscillator 22 has a second oscillation transistor 22a, two feedback capacitors 22b and 22c, a second strip line 22d as an inductance device, and a second varactor diode 22e.

The oscillation frequency of each of the oscillators 21 and 22 is changed according to a control voltage (Vc) applied to each of the varactor diodes 21e and 22e. Oscillation signals are derived from the emitters of the oscillation transistors 21a and 22a.

The coupled circuit 23 has two coupling capacitors 23a and 23b which are connected in series. One end of one of the coupling capacitors, 23a, is connected to the emitter of the first oscillation transistor 21a. One end of the other coupling capacitor 23b is connected to the emitter of the second oscillation transistor 22a.

The amplifier 24 is an emitter-grounded aperiodic wide-band amplifier. A power supply voltage (Vb) is applied to the collector of a transistor 24a for amplification via a choke inductor 24b. The connection point of the coupling capacitors 23a and 23b is connected to the base of the transistor 24a for amplification.

The power supply voltage is applied to either the collector of the first oscillation transistor 21a or the collector of the second oscillation transistor 22a by the change-over switch 25.

When the power supply voltage is applied to the first oscillator 21 by the change-over switch 25, an oscillation signal appearing at the emitter of the first oscillation transistor 21a is supplied to the amplifier 24 via the coupling capacitor 23a. When the power supply voltage is applied to the second oscillator 22, an oscillation signal appearing at the emitter of the second oscillation transistor 22a is supplied to the amplifier 24 via the coupling capacitor 23b.

The level of each of the oscillation signals supplied to the amplifier 24 is influenced by the capacitance value of the coupling capacitor 23a or 23b. The capacitance value is usually set to a few pF (2 to 5 pF).

As described above, in the conventional two-band oscillating device, oscillation signals in two frequency bands are supplied to the amplifier via the corresponding coupling capacitors. Consequently, the two oscillators are coupled to each other via the coupling capacitors and each of the oscillators is a load on the other oscillator. It causes a problem such that the level of the oscillation signal supplied to the amplifier is reduced.

In order to solve the problem (reduction in level), it is sufficient to increase the capacitance value of each of the coupling capacitors. In this case, however, the coupling of the oscillators becomes tight, the oscillators are influenced by each other, and a problem such that each of the oscillation frequencies changes arises.

In order to reduce the coupling of the oscillators by decreasing the capacitance value of the coupling capacitors and increase the level of the oscillation signal, it is necessary to pass a large current to the oscillation transistors. It however causes a problem such that the power savings cannot be achieved.

JPO1173908 discloses a similar two-band oscillator using grounded gate oscillator transistors coupled to one output means of source follower transistors selected by switching a power supply.

It is therefore an object of the invention to provide a two-band oscillating device which solves all of the problems, has loose coupling of two oscillators and can supply an oscillation signal to an amplifier without reducing the level of the signal.

As means for solving the problems, according to the invention, there is provided a two-band oscillating device as claimed in claim 1 or in claim 3.

Futher, preferable embodiments of the invention are defined in the dependent claims.

Embodiments of the invention will now be described, by way of example only, with reference to the accompanying drawings, in which:
Fig. 1 is a circuit diagram showing the construction of a two-band oscillating device according to the invention.
Fig. 2 is a circuit diagram showing another construction of a two-band oscillating device according to the invention.
Fig. 3 is a circuit diagram showing further another construction of a two-band oscillating device according to the invention.
Fig. 4 is a circuit diagram showing further another construction of a two-band oscillating device of the invention.
Fig. 5 is a circuit diagram showing the construction of a conventional two-band oscillating device.

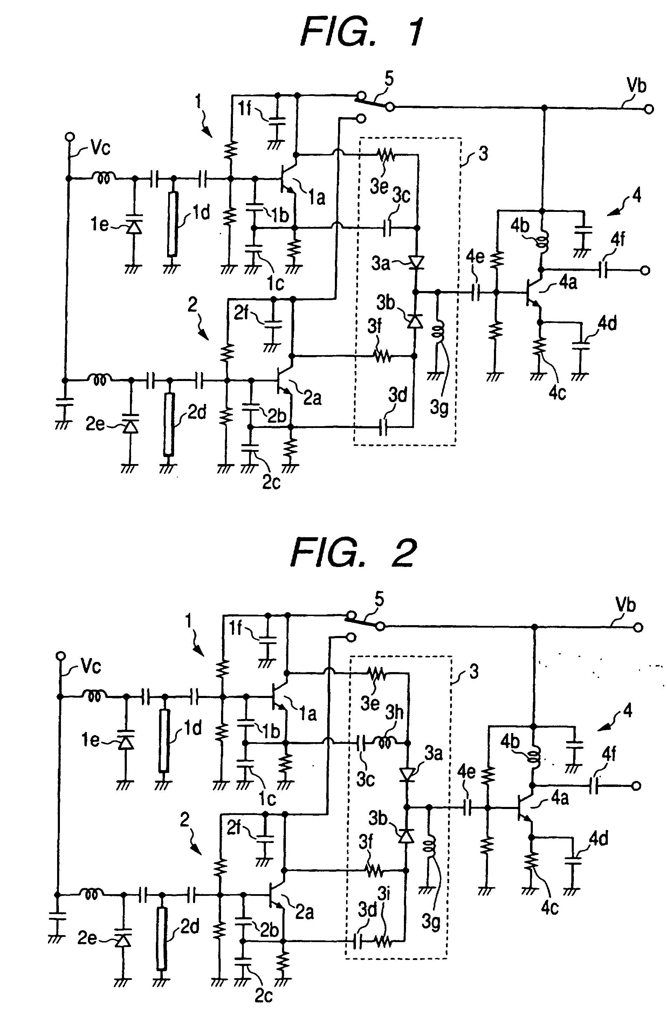

Fig. 1 shows the construction of a two-band oscillating device of the invention, which comprises a first oscillator 1, a second oscillator 2, a coupled circuit 3 and an amplifier 4. The first oscillator 1 produces an oscillation signal in a first frequency band of low frequencies of 880 MHz to 940 MHz. The second oscillator 2 produces an oscillation signal in a second frequency band of 1805 MHz to 1920 MHz which is higher than the first frequency band. Each of the first and second oscillators 1 and 2 takes the form of a collector-grounded voltage-controlled Colpitts oscillator. A power supply voltage (Vb) is applied to either the first oscillator 1 or second oscillator 2 by a voltage switching means 5. The oscillator to which the power supply voltage is applied operates.

The first oscillator 1 comprises a first oscillation transistor 1a, first feedback capacitors 1b and 1c, a first strip line 1d as an inductance device, and a first varactor diode 1e. The collector of the first oscillation transistor 1a is connected to the ground via a first grounding capacitor 1f so as to pass high frequencies. By a control voltage Vc applied to the first varactor diode 1e, the oscillation frequency in the first frequency band is changed and an oscillation signal is obtained from the emitter.

The second oscillator 2 comprises a second oscillation transistor 2a, second feedback capacitors 2b and 2c, a second strip-line 2d as an inductance device, and a second varactor diode 2e. The collector of the second oscillation transistor 2a is connected to the ground via a second grounding capacitor 2f so as to pass high frequencies. By a control voltage Vc applied to the first varactor diode 2e, the oscillation frequency in the second frequency band is changed and an oscillation signal is obtained from the emitter.

The coupled circuit 3 has: first and second switching diodes 3a and 3b whose cathodes are connected to each other; a first coupling capacitor 3c connected between the anode of the first switching diode 3a and the emitter of the first oscillation transistor 1a; a second coupling capacitor 3d connected between the anode of the second switching diode 3b and the emitter of the second oscillation transistor 2a; a first feeding resistor 3e for connecting the collector of the first oscillation transistor 1a and the anode of the first switching diode 3a so as to pass almost direct currents; a second feeding resistor 3f for connecting the collector of the second oscillation transistor 2a and the anode of the second switching diode 3b so as to pass almost direct currents; and a choke inductor 3g for connecting the cathodes of the switching diodes 3a and 3b to the ground so as to pass almost direct currents.

The amplifier 4 takes the form of an emitter-grounded aperiodic wide-band amplifier. A power supply voltage is applied to the collector of a transistor 4a for amplification via a choke inductor 4b. The emitter is connected to the ground via a bias resistor 4c and a bypass capacitor 4d. The base as an input terminal of the amplifier 4 is connected to the cathodes of the first and second switching diodes 3a and 3b via a DC blocking capacitor 4e.

For example, when the power supply voltage is applied to the collector of the first oscillation transistor 1a by the voltage switching means 5, the first oscillator 1 operates, a current is passed through the first feeding resistor 3e, the first switching diode 3a and the choke inductor 3g, and the first switching diode 3a is made conductive (ON). Then, the oscillation signal appearing at the emitter of the first oscillation transistor 1a is supplied to the base of the transistor 4a for amplification via the first coupling capacitor 3c, first switching diode 3a and DC blocking capacitor 4e. The amplified oscillation signal is outputted from the collector of the transistor 4a for amplification via the DC blocking capacitor 4f.

When the power supply voltage is applied to the collector of the second oscillation transistor 2a by the voltage switching means 5, the second oscillator 2 operates. Simultaneously, a current is passed through the second feeding resistor 3f, second switching diode 3b and choke inductor 3g, so that the second switching diode 3b is made conductive (ON). The oscillation signal appearing at the emitter of the second oscillation transistor 2a is supplied to the base of the transistor 4a for amplification via the second coupling capacitor 3d, second switching diode 3b and DC blocking capacitor 4e. Simultaneously, the amplified oscillation signal is outputted from the collector of the transistor 4a for amplification via the DC blocking capacitor 4f.

As described above, in the two-band oscillating device, the oscillation signal in the first frequency band or the oscillation signal in the second frequency band is supplied to the amplifier 4 by the first switching diode 3a which is made conductive in association with the operating state of the first oscillator and the second switching diode 3b which is made conductive in association with the operating state of the second oscillator. Consequently, one of the switching diodes is certainly non-conducting and the first and second oscillators 1 and 2 are not coupled to each other. Therefore, one of the oscillators does not become a load on the other oscillator and the level of the oscillation signal supplied to the amplifier 4 is not reduced.

Fig. 2 shows the construction of a modification of the two-band oscillating device of the invention. An inductor 3h is connected in series to the first coupling capacitor 3c connected to the first oscillator 1 for outputting the oscillation signal in the first frequency band which is low. A resistor 3i is connected in series to either the first coupling capacitor 3c or the second coupling capacitor 3d (the second coupling capacitor 3d in Fig. 2). Since the resistor 3i has the function of level adjustment, it is desirable to connect it to the coupling capacitor which is connected to the oscillator that produces the oscillation signal of a higher level. The other construction is similar to that shown in Fig. 1.

The resonance frequency by the first coupling capacitor 3c and the inductor 3h is adjusted to an almost center frequency in the first frequency band. With the construction, the passage of higher harmonics of the oscillation signal in the first frequency band is checked by the inductor 3h, so that the level of the oscillation signal supplied to the amplifier 4 is reduced.

Even when the amplifier 4 is of a wide band, the level of the higher harmonics to be outputted is reduced and the occurrence of an interference signal in a mixer (not shown) connected at the post stage of the amplifier 4 can be prevented.

Even when the level of the oscillation signal in the second frequency band is higher than that of the oscillation signal in the first frequency band, the level of the oscillation signal in the second frequency band is reduced by the resistor 3i connected in series to the second coupling capacitor 3d. Consequently, the levels of two oscillation signals supplied to the amplifier 4 can be adjusted.

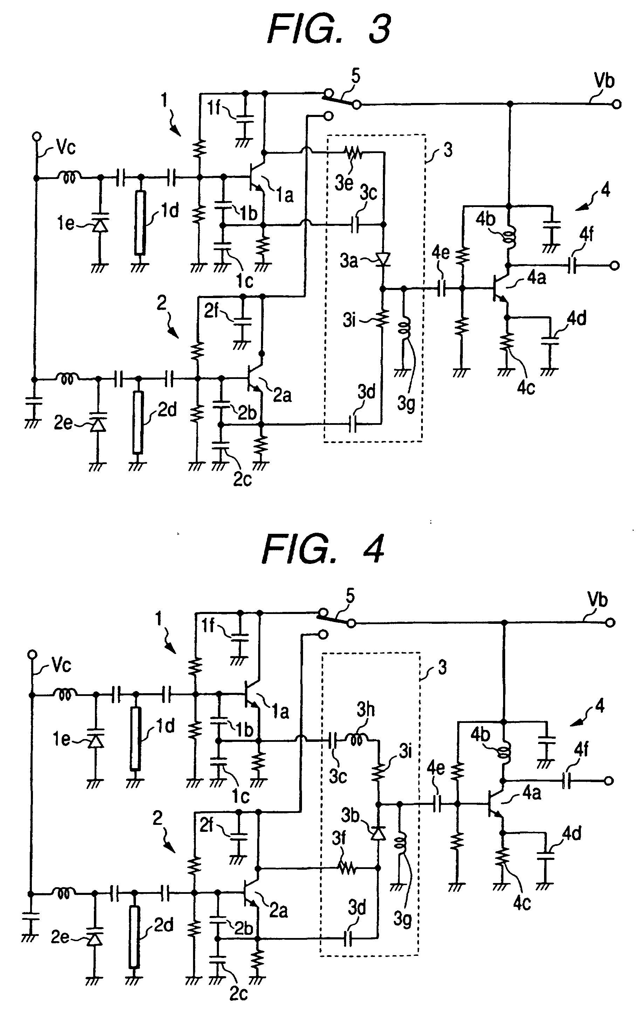

Fig. 3 shows the construction of another modification of the two-band oscillating device. Either the first switching diode 3a or the second switching diode 3b in the coupled circuit 3 in Fig. 1 is replaced by the resistor 3i. In association with the replacement, either the first resistor 3e or the second resistor 3f for voltage supply is eliminated. In Fig. 3, the second switching diode 3b in Fig. 1 is replaced by the resistor 3i and the second feeding resistor 3f is eliminated.

When the level of the oscillation signal in the second frequency band is higher than that of the oscillation signal in the first frequency band, by reducing the level of the oscillation signal in the second frequency band by the resistor 3i, the levels of the two oscillation signals to be supplied to the amplifier 4 can be adjusted. Since the coupling between the first and second oscillators 1 and 2 becomes loose by the resistor 3i, even when no switching diode (the second switching diode 3b in this case) is provided, reduction in level of the oscillation signal in the first frequency band is small.

Fig. 4 shows the construction of further another modification of a two-band oscillating device.
The first switching diode 3a in the coupled circuit 3 in Fig. 1 is replaced by the level adjusting resistor 3i. In association with the replacement, the resistor 3e for voltage supply is eliminated and the inductor 3h is connected in series to the first coupling capacitor 3c. The construction is suited to the case where the level of the oscillation signal in the first frequency band is higher than that of the oscillation signal in the second frequency band, and the frequency of the oscillation signal in the first frequency band is lower than that of the oscillation signal in the second frequency band. The other construction is the same as that of Fig. 1.

In the construction, the level of the oscillation signal in the first frequency band outputted from the first oscillator 1 can be adjusted. The level of higher harmonics of the oscillation signal in the first frequency band supplied to the amplifier 4 can be reduced by the inductor 3h connected in series to the first coupling capacitor 3c.

Obviously, voltage switching means for applying a power supply voltage to the first oscillator 1 or second oscillator 2 can be constructed by a switching diode or switching transistor.

As described above, the two-band oscillating device of the invention comprises: the first switching diode connected in series between the first oscillator and the amplifier; and the second switching diode connected in series between the second oscillator and the amplifier. By the application of the power supply voltage, the first oscillator is operated and the first switching diode is made conductive, or the second oscillator is operated and the second switching diode is made conductive. Consequently, one of the switching diodes is certainly non-conducting and the first and second oscillators are not coupled to each other. Thus, one of the oscillators does not become a load on the other oscillator, and the level of an oscillation signal supplied to the amplifier is not reduced.

According to the two-band oscillating device of the invention, the anode of the first switching diode is connected to the collector of the first oscillation transistor so as to pass almost direct currents and is connected to the emitter via the first coupling capacitor, the anode of the second switching diode is connected to the collector of the second oscillation transistor so as to pass almost direct currents and is connected to the emitter via the second coupling capacitor, each of cathodes of the first and second switching diodes is connected to an input terminal of the amplifier and is also connected to the ground so as to pass almost direct currents, and the power supply voltage is applied to either the collector of the first oscillation transistor or the collector of the second oscillation transistor by the voltage.switching means. Consequently, the operation of the oscillators and the conductive state of the switching diodes can be made associated with each other by the power source voltage applied to the collector of each of the oscillation transistors.

According to the two-band oscillating device of the invention, a resistor is connected in series to either the first coupling capacitor or the second coupling capacitor. When the resistor is connected to the coupling capacitor through which an oscillation signal of a higher level passes, the level of the oscillation signal supplied to the amplifier can be reduced. Thus, the levels of the two oscillation signals supplied to the amplifier can be matched.

The two-band oscillating device of the invention comprises: the switching diode connected in series between the first oscillator and the amplifier; and the resistor connected in series between the second oscillator and the amplifier. By the application of the power supply voltage, the first oscillator is operated and the switching diode is made conductive. Consequently, the two oscillators can be loosely coupled to each other by one switching diode and the resistor, so that the cost can be reduced. When the level of the oscillation signal in the second frequency band is higher tan that of the oscillation signal in the first frequency band, the level can be reduced by the resistor, thereby enabling the levels of the two oscillation signals supplied to the amplifier to be matched.

According to the two-band oscillating device of the invention, the anode of the switching diode is connected to the collector of the first oscillation transistor so as to pass almost direct currents and is connected to the emitter via the first coupling capacitor. A resistor is connected in series between the cathode of the switching diode and the emitter of the second oscillation transistor, and the second coupling capacitor is connected in series to the resistor. The cathode of the switching diode is connected to the input terminal of the amplifier and is connected to the ground so as to pass almost direct currents. The power supply voltage is applied to either the collector of the first oscillation transistor or the collector of the second oscillation transistor by the voltage switching means. Thus, the switching diode can be made conductive in association with the operation of the first oscillator.

In the two-band oscillating device of the invention, the frequency of the oscillation signal in the first frequency band is set to be lower than that of the oscillation signal in the second frequency band, an inductor is connected in series to the first coupling capacitor, and a resonance frequency by the first coupling capacitor and the inductor is set within the first frequency band. Consequently, passage of the higher harmonics of the oscillation signal in the first frequency band can be blocked by the inductor 3h.

Even when the amplifier is an amplifier of a wide band, the level of higher harmonics to be outputted is reduced and the occurrence of an interference signal in a mixer or the like connected at the next stage of the amplifier can be prevented.

## Claims

1. A two-band oscillating device comprising:
a first oscillator (1) having a first oscillation transistor (1a) for outputting an oscillation signal in a first frequency band; a second oscillator (2) having a second oscillation transistor (2a) for outputting an oscillation signal in a second frequency band; voltage switching means (5) for applying a power supply voltage to either the first oscillator (1) or second oscillator (2) in an alternative way; and an amplifier (4) for amplifying either the oscillation signal in the first frequency band or the oscillation signal in the second frequency band,
wherein
an anode of a first switching diode (3a) is connected to a collector of the first oscillation transistor (1a) so as to pass almost direct currents;
a first coupling capacitor (3c) is connected between an emitter of the first oscillation transistor (1a) and an anode of the first switching diode (3a);
an anode of the second switching diode (3b) is connected to a collector of the second oscillation transistor (2a) so as to pass almost direct currents;
and a second coupling capacitor (3d) is connected between an emitter of the second oscillation transistor (2a) and an anode of the second switching diode (3b);
wherein each of the cathodes of the first switching diode (3a) and the second switching diode (3b) is connected to an input terminal of the amplifier (4) and is also connected to the ground so as to pass almost direct currents; when the power supply voltage is applied to the collector of the first oscillation transistor (1a) by the voltage switching means (5) the first oscillator (1) is operated to make the first switching diode (3a) conductive; and when the power supply voltage is applied to the collector of the second oscillation transistor (2a) by the voltage switching means (5) the second oscillator (2) is operated to make the second switching diode (3b) conductive.

2. A two-band oscillating device according to claim 1, wherein a resistor (3i) is connected in series to either the first coupling capacitor or the second coupling capacitor.

3. A two-band oscillating device comprising:
a first oscillator (1) for outputting an oscillation signal in a first frequency band;
a second oscillator (2) for outputting an oscillation signal in a second frequency band;
voltage switching means (5) for applying a power supply voltage to either the first oscillator or the second oscillator in an alternative way;
an amplifier (4) for amplifying either the oscillation signal in the first frequency band or the oscillation signal in the second frequency band;
wherein a serially connected circuit of a first coupling capacitor (3c) and a switching diode (3a) for supplying an oscillation signal in the first frequency band to the amplifier is connected between the first oscillator (1) and the amplifier, and
a serially connected circuit of a second coupling capacitor (3d) and a resistor (3i) for supplying the oscillation signal in the second frequency band to the amplifier is connected between the second oscillator (2) and the amplifier (4), and
wherein by the voltage switching means (5), the first oscillator (1) is operated and the switching diode (3a) is made conductive, or by the voltage switching means (5), the second oscillator (2) is operated and at the same time the switching diode (3a) is made non-conductive.

4. A two-band oscillating device according to claim 3, wherein the first oscillator has a first oscillation transistor (1a), the second oscillator has a second oscillation transistor (2a), the anode of the switching diode is connected to the collector of the first oscillation transistor so as to pass almost direct currents and is connected to the emitter via the first coupling capacitor, the resistor is connected in series between the cathode of the switching diode and the emitter of the second oscillation transistor, the second coupling capacitor is connected to the resistor in series, the cathode of the switching diode is connected to an input terminal of the amplifier and is also connected to the ground so as to pass almost direct currents, and the power supply voltage is applied to either the collector of the first oscillation transistor or the collector of the second oscillation transistor by the voltage switching means.

5. A two-band oscillating device according to any preceding claim, wherein the frequency of the oscillation signal in the first frequency band is set to be lower than that of the oscillation signal in the second frequency band, and an inductor (3h) is connected in series to the first coupling capacitor, and a resonance frequency by the first coupling capacitor and the inductor is set within the first frequency band.

## Patentansprüche

1. Zweiband-Oszillatorvorrichtung, umfassend:
einen ersten Oszillator (1) mit einem ersten Oszillationstransistor (1a) zum Ausgeben eines Oszillationssignals in einem ersten Frequenzband; einen zweiten Oszillator (2) mit einem zweiten Oszillationsttansistor (2a) zum Ausgeben eines Oszillationssignals in einem zweiten Frequenzband; eine Spannungs-Umschalteinrichtung (5) zum Anlegen einer Versorgungsspannung an entweder den ersten Oszillator (1) oder den zweiten Oszillator (2) in alternativer Weise, und einen Verstärker (4) zum Verstärken entweder des Oszillationssignals im ersten Frequenzband oder des Oszillationssignals im zweiten Frequenzband, wobei
eine Anode einer ersten Schaltdiode (3a) mit einem Kollektor des ersten Oszillationstransistors (1a) verbunden ist, um nahezu Gleichströme durchzulassen;
ein erster Koppelkondensator (2c) zwischen einen Emitter des ersten Oszillationstransistors (1a) und eine Anode der ersten Schaltdiode (3a) geschaltet ist;
eine Anode der zweiten Schaltdiode (3a) an einen Kollektor des zweiten Oszillationstransistors (3a) angeschlossen ist, um nahezu Gleichströme durchzulassen,
und ein zweiter Koppelkondensator (3d) zwischen einen Emitter des zweiten Oszillationstransistors (2a) und eine Anode der zweiten Schaltdiode (3b) gelegt ist;
wobei jede Kathode der ersten Schaltdiode (3a) und der zweiten Schaltdiode (3b) an einen Eingangsanschluss des Verstärkers (4) angeschlossen ist und außerdem mit Masse verbunden ist, um nahezu Gleichströme durchzulassen, wobei dann, wenn die Versorgungsspannung an den Kollektor des ersten Oszillationstransistors (1a) über die Spannungsumschalteinrichtung (5) gelegt wird, der erste Oszillator (1) betrieben wird, um die erste Schaltdiode (3a) leitend zu machen; und dann, wenn die Versorgungsspannung an den Kollektor des zweiten Oszillationstransistors (2a) über die Spannungsumschalteinrichtung (5) gelegt wird, der zweite Oszillator (2) betrieben wird, um die zweite Schaltdiode (3b) leitend zu machen.

2. Vorrichtung nach Anspruch 1, bei der ein Widerstand (3i) in Reihe zu entweder dem ersten oder dem zweiten Koppelkondensator geschaltet ist.

3. Oszillatorvorrichtung, umfassend :
einen ersten Oszillator (1) zum Ausgeben eines Oszillationssignals in einem ersten Frequenzband;
einen zweiten Oszillator (2) zum Ausgeben eines Oszillationssignals in einem zweiten Frequenzband;
eine Spannungsumschalteinrichtung (5) zum Anlegen einer Versorgungsspannung an entweder den ersten Oszillator oder den zweiten Oszillator in alternativer Weise;
einen Verstärker (4) zum Verstärken entweder des Oszillationssignals im ersten Frequenzband oder desjenigen des zweiten Frequenzbands;
wobei eine Serienschaltung aus einem ersten Koppelkondensator (3c) und einer Schaltdiode (3a) zum Zuführen eines Oszillationssignals des ersten Frequenzbands zu dem Verstärker zwischen dem ersten Oszillator (1) und dem Verstärker liegt, und
eine Serienschaltung aus einem zweiten Koppelkondensator (3d) und einem Widerstand (3i) zum Zuführen des Oszillationssignals des zweiten Frequenzbands zu dem Verstärker zwischen den zweiten Oszillator (2) und den Verstärker (4) gelegt ist, und
wobei durch die Spannungsumschalteinrichtung (5) der erste Oszillator (1) betätigt und die Schaltdiode (3a) leitend gemacht wird, oder von der Spannungsumschalteinrichtung (5) der zweite Oszillator (2) betätigt und gleichzeitig die Schaltdiode (3a) nicht-leitend gemacht wird.

4. Vorrichtung nach Anspruch 3, bei der der erste Oszillator einen ersten Oszillationstransistor (1a) aufweist, der zweite Oszillator einen zweiten Oszillationstransistor (2a) aufweist, die Anode der Schaltdiode an den Kollektor des ersten Oszillationstransistors angeschlossen ist, um nahezu Gleichströme durchzulassen, und an den Emitter über den ersten Koppelkondensator angeschlossen ist, der Widerstand in Reihe zwischen der Kathode der Schaltdiode und dem Emitter des Oszillationstransistors liegt, der zweite Koppelkondensator in Reihe an den Widerstand angeschlossen ist, die Kathode der Schaltdiode an den Eingangsanschluss des Verstärkers und außerdem an Masse angeschlossen ist, um nahezu Gleichströme durchzulassen, und die Versorgungsspannung an entweder den Kollektor des ersten Oszillationstransistors oder an den Kollektor des zweiten Oszillationstransistors über die Spannungsumschalteinrichtung angelegt wird.

5. Vorrichtung nach einem vorhergehenden Anspruch, bei der die Frequenz des Oszillationssignals in dem ersten Frequenzband niedriger eingestellt ist als diejenige des Oszillationssignals im zweiten Frequenzband, und eine Induktivität (3h) in Reihe an den ersten Koppelkondensator angeschlossen ist, wobei die Resonanzfrequenz des ersten Koppelkondensators und der Induktivität so eingestellt ist, dass sie in dem ersten Frequenzband liegt.

## Revendications

1. Dispositif d'oscillateur à deux bandes, comprenant :
un premier oscillateur (1) possédant un premier transistor monté en oscillateur (1a) permettant de sortir un signal oscillant dans une première bande de fréquence ; un second oscillateur (2) possédant un second transistor monté en oscillateur (2a) permettant de sortir un signal oscillant dans une seconde bande de fréquence ; un moyen de commutation de tension (5) permettant d'appliquer une tension d'alimentation soit au premier oscillateur (1), soit au second oscillateur (2), en alternance ; et un amplificateur (4) permettant d'amplifier soit le signal oscillant dans la première bande de fréquence, soit le signal oscillant dans la seconde bande de fréquence, dans lequel :
une anode d'une première diode de commutation (3a) est connectée à un collecteur du premier transistor monté en oscillateur (1a), de façon à faire passer des courants presque continus,
un premier condensateur de couplage (3c) est connecté entre un émetteur du premier transistor monté en oscillateur (1a) et une anode de la première diode de commutation (3a) ;
une anode de la seconde diode de commutation (3b) est connectée à un collecteur du second transistor monté en oscillateur (2a), de façon à faire passer des courants presque continus;
et un second condensateur de couplage (3d) est connecté entre un émetteur du second transistor monté en oscillateur (2a), et une anode de la seconde diode de commutation (3b) ;
et dans lequel chacune des cathodes de la première diode de commutation (3a) et de la seconde diode de commutation (3b) est connectée à une borne d'entrée de l'amplificateur (4) et est également reliée à la masse, de façon à faire passer des courants presque continus ; de sorte que lorsque la tension d'alimentation est appliquée au collecteur du premier transistor monté en oscillateur (1a) grâce au moyen de commutation de tension (5), le premier oscillateur (1) fonctionne pour rendre la première diode de commutation (3a) conductrice ; et, lorsque la tension d'alimentation est appliquée au collecteur du second transistor monté en oscillateur (2a) grâce au moyen de commutation de tension (5), le second oscillateur (2) fonctionne pour rendre la seconde diode de commutation (3b) conductrice.

2. Dispositif d'oscillateur à deux bandes selon la revendication 1, dans lequel une résistance (3i) est connectée en série soit au premier condensateur de couplage, soit au second condensateur de couplage.

3. Dispositif d'oscillateur à deux bandes, comprenant :
un premier oscillateur (1) permettant de sortir un signal oscillant dans une première bande de fréquence ;
un second oscillateur (2) permettant de sortir un signal oscillant dans une seconde bande de fréquence ;
un moyen de commutation de tension (5) permettant d'appliquer une tension d'alimentation soit au premier oscillateur, soit au second oscillateur, en alternance ; et un amplificateur (4) permettant d'amplifier soit le signal oscillant dans la première bande de fréquence, soit le signal oscillant dans la seconde bande de fréquence ; dans lequel :
un circuit connecté en série d'un premier condensateur de couplage (3c) et d'une diode de commutation (3a), permettant d'alimenter l'amplificateur avec un signal oscillant dans la première bande de fréquence, est connecté entre le premier oscillateur (1) et l'amplificateur (4), et
un circuit connecté en série d'un second condensateur de couplage (3d) et d'une résistance (3i), permettant d'alimenter l'amplificateur avec le signal oscillant dans la seconde bande de fréquence, est connecté entre le second oscillateur (2) et l'amplificateur (4), et
dans lequel, grâce au moyen de commutation de tension (5), le premier oscillateur (1) fonctionne et la diode de commutation (3a) est rendue conductrice, ou grâce au moyen de commutation de tension (5), le second oscillateur (2) fonctionne et, en même temps, la diode de commutation (3a) est rendue non-conductrice.

4. Dispositif d'oscillateur à deux bandes selon la revendication 3, dans lequel le premier oscillateur possède un premier transistor monté en oscillateur (1a), le second oscillateur possède un second transistor monté en oscillateur (2a), l'anode de la diode de commutation est connectée au collecteur du premier transistor monté en oscillateur, de façon à faire passer des courants presque continus, et est connectée à l'émetteur via le premier condensateur de couplage, la résistance est connectée en série entre la cathode de la diode de commutation et l'émetteur du second transistor monté en oscillateur, le second condensateur de couplage est connecté à la résistance en série, la cathode de la diode de commutation est connectée à une borne d'entrée de l'amplificateur et est également reliée à la masse, de façon à faire passer des courants presque continus, et la tension d'alimentation est appliquée soit au collecteur du premier transistor monté en oscillateur, soit au collecteur du second transistor monté en oscillateur, grâce au moyen de commutation de tension.

5. Dispositif d'oscillateur à deux bandes selon l'une quelconque des revendications précédentes, dans lequel la fréquence du signal oscillant, dans la première bande de fréquence, est définie pour être inférieure à celle du signal oscillant dans la seconde bande de fréquence, et un inducteur (3h) est connecté en série au premier condensateur de couplage, et une fréquence de résonance du premier condensateur de couplage et de l'inducteur est définie à l'intérieur de la première bande de fréquence.
